# EUROPEAN PATENT APPLICATION

(11) **EP 0 949 672 A2**
(43) Date of publication of application: **13.10.1999**
(21) Application number: 99201048.8
(22) Date of filing: 07.04.1999
(51) Int. Cl.: H01L 21/768, H01L 23/485

(54) **PO Flow for copper metallization**

(30) Priority: 08.04.1998 US 81098 P
(71) Applicant: TEXAS INSTRUMENTS INCORPORATED, Dallas Texas 75265 (US)
(72) Inventor: Jain, Manoj K., Plano, Texas (US)
(74) Representative: Holt, Michael

(57) **Abstract**

A PO flow for copper metallization. After the copper metal interconnects (102) are formed, a dielectric stack (112) is formed, patterned and etched to expose the areas of copper designated as bondpads (110). A conductive layer (114) or multilayer with acceptable bonding characteristics is deposited over the structure. For example, aluminum (or alloy) with underlying barrier layer(s) may be used. The conductive layer (114) is then chemically-mechanically polished (CMP'd) to remove the conductive layer (114) from the surface of the dielectric stack, leaving the conductive layer (114) over the exposed copper (110).

## Description

### FIELD OF THE INVENTION

The invention is generally related to the field of interconnect layers in semiconductor devices and more specifically to copper metallization.

### BACKGROUND OF THE INVENTION

As integrated circuits continue to scale to smaller and smaller dimensions, the widths of interconnects between the devices of the integrated circuit must also scale. Traditionally, aluminum was the material of choice for the interconnect lines. However, as the width of an interconnect lines scales downward, the resistivity increases. Therefore, lower resistivity materials, such as copper are being investigated.

After active devices are formed in a semiconductor body, interconnects between the devices are formed using varying numbers of interconnect layers. Each interconnect layer consists of a metal interconnect and a interlevel dielectric to isolate the metal interconnect. After the interconnect layers are formed, certain areas of the metal interconnects must be opened back up (exposed) for bonding to connect to other circuits. This process is typically referred to as a PO flow. The traditional PO flow for aluminum (or aluminum alloy) interconnects consists of deposition of a dielectric stack consisting of an oxide layer and/or a silicon nitride layer over the patterned aluminum leads. Subsequent to the dielectric stack deposition ( and optional planarization), photoresist is coated, exposed using a PO mask to open-up the bondpads, developed and optionally baked. Finally, the dielectric stack is etched in the resist openings. The titanium nitride (TiN) layer, which may be present as a top coat over the aluminum (or aluminum alloy leads may also be etched, exposing the aluminum (or alloy) for bonding.

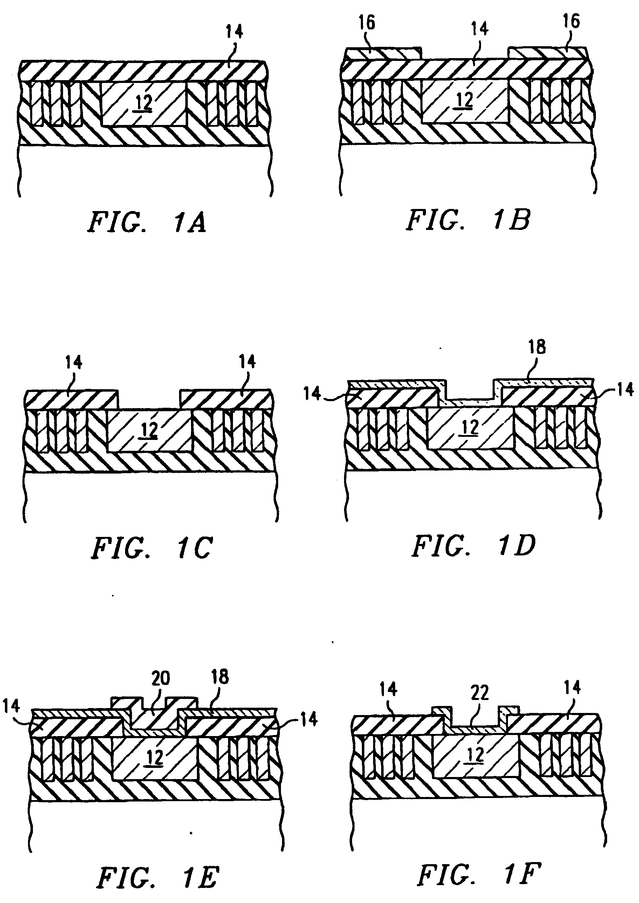

Copper interconnects have been presented as an alternative to aluminum. Copper interconnects may be fabricated by using a damascene flow which consists of patterning and etching the interconnect geometry in the dielectric, deposition of one or more barrier layers, copper filling and polishing to remove copper from the top surface. this leaves behind copper embedded in the etched geometry in the dielectric. Then, similar to the aluminum PO flow, a dielectric stack 14 consisting of nitride and/or oxide layers is deposited on top of the exposed copper 12, as shown in FIG. 1A. Then, photoresist 16 is coated, exposed using a PO mask to open up the bond pads, developed and optionally baked, as shown in FIG. 1B. Finally the dielectric stack 14 is etched in the resist openings, thus exposing the copper, as shown in FIG. 1C.

However, bonding of the gold or aluminum bond wires to copper bonds pads is not preferred due to reasons such as poor adhesion of bond wires to copper and corrosion of copper. Therefore, subsequent to the dielectric stack etching and cleaning, an optional barrier layer (such as TiN, TiW, Ta, TaN, WNₓ or Ti) is deposited. Over the barrier layer, aluminum or aluminum alloy (alloy elements: Cu, Si, Ta) is deposited, followed by an optional anti-reflective coating layer such as TiN. The barrier layers, aluminum (or alloy) and ARC layers are illustrated in FIG. 1D by reference numeral 18. Then, a second patterning step is performed using a reverse pattern mask and photoresist 20 is patterned in order to cover the bondpads, as shown in FIG. 1E. The aluminum and barrier layers 18 outside of the bondpads are etched away. This leaves a capping aluminum layer 22 over the copper bondpads. Bonding is done to the aluminum cap 22.

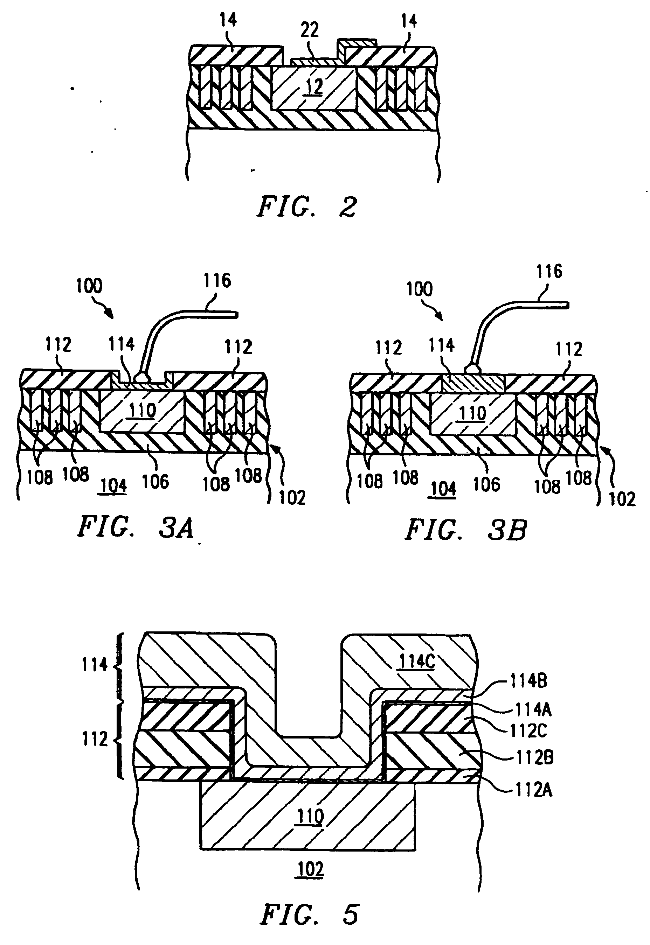

The process adds a photolithography step and requires good alignment between the first and second patterning steps. A misalignment between the first and second patterning steps can result in the structure shown in FIG. 2. Misalignment can expose the copper to corrosion and can result in an attempt to bond directly to the copper instead of the aluminum cap 22.

### SUMMARY OF THE INVENTION

A PO flow for copper metallization is disclosed herein. After the copper metal interconnects are formed, a dielectric stack is formed, patterned and etched to expose the areas of copper designated as bondpads. A conductive layer or multilayer with acceptable bonding characteristics is deposited over the structure. For example, aluminum (or alloy) with underlying barrier layer(s) may be used. The conductive layer is then chemically-mechanically polished (CMP'd) to remove the conductive layer from the surface of the dielectric stack, leaving the conductive layer over the exposed copper.

An advantage of the invention is providing a PO flow for a material with poor bonding characteristics that reduces the photolithography steps over the prior art.

Another advantage of the invention is providing a PO flow for a material with poor bonding characteristics that includes a self-aligned capping layer.

These and other advantages will be apparent to those of ordinary skill in the art having reference to the specification in conjunction with the drawings.

### BRIEF DESCRIPTION OF THE DRAWINGS

In the drawings:
FIGs. 1A-1E are cross-sectional diagrams of a prior art PO flow for copper metallization;
FIG. 2 is a cross-sectional diagram showing a misalignment that can occur using the prior art PO flow;
FIGs. 3A-3B are cross-sectional diagrams of a bondpad constructed according to the invention;
FIGs 4A-4E are cross-sectional diagrams illustrating the PO flow according to the invention; and
FIG. 5 is a cross-sectional diagram of a specific bondpad embodiment according to the invention.

### DETAILED DESCRIPTION OF THE EMBODIMENTS

The invention will now be described in conjunction with a PO flow for copper metallization. It will be apparent to those of ordinary skill in the art that the benefits of the inventions may be applied to other metalization materials that are unsuitable for the bonding process.

A bondpad 100 for copper metallization is shown in Fig. 3A. Interconnect layer 102 is located on a semiconductor body 104. Semiconductor body 104 typically comprises a substrate, active devices, such as transistors, and one or more additional interconnect layers. Interconnect layer 102 comprises an interlevel dielectric (ILD) 106, copper interconnect lines 108 and copper pad 110. ILD 106 may comprise any suitable dielectric, such as a silicon dioxide (optionally doped with B, P, or F) or a low-K dielectric material. Copper interconnect lines 108 and copper pad 110 may comprise one or more barrier layer underlying a copper layer. Suitable barrier layers are known in the art. For example, Ta, TaN, WNₓ, TiN, TiW, Ti or a combination thereof may be used.

A PO dielectric 112 covers ILD 106 and copper interconnect lines 108 but does not cover portions of copper pad 110. PO dielectric 112 may comprise the same materials used in traditional aluminum PO flows. For example, oxide and/or silicon-nitride layers may be used. A capping layer 114 is located over copper pad 110. Capping layer 114 comprises a conductive material different from that of the pad 110. The material for capping layer 114 is chosen to provide improved suitability to the bonding process. For example, it must be resistant to corrosion and provide good adhesion for the bondwires 116. The preferred material for capping layer 114 is aluminum or an aluminum alloy with one or more underlying barrier layers. Suitable barrier layers are known in the art. For example, TiN, TiW, Ti or a combination thereof may be used. An aluminum alloy with alloy elements of Cu, Si, Ta is suitable. Capping layer 114 can be recessed as shown in FIG. 3A or it can be planar as shown in FIG. 3B.

A PO flow for copper metallization according to the invention will now be discussed. A semiconductor body 104 is processed through the formation of active devices, such as transistors, and one or more interconnect layers. The upper interconnect layer 102 comprises copper metallization (including any desired barrier layers) embedded in an ILD 106.

Referring to FIG. 4A, a PO dielectric 112 is deposited over ILD 106 and upper interconnect layer 102. The PO dielectric 112 may comprises a nitride, nitride/oxide, nitride/oxide/nitride, nitride/low-K material/nitride, or a low K material such as polymide. The thicknesses of each layer may be in the range of 300-10000Å. As an example, PO dielectric 112 may comprise a thin nitride layer in the range of 300-10000Å thick with an optional overlying oxide layer in the range of 300-10000Å thick. It will be apparent to those of ordinary skill in the art that other dielectric materials and thickness may alternatively be used.

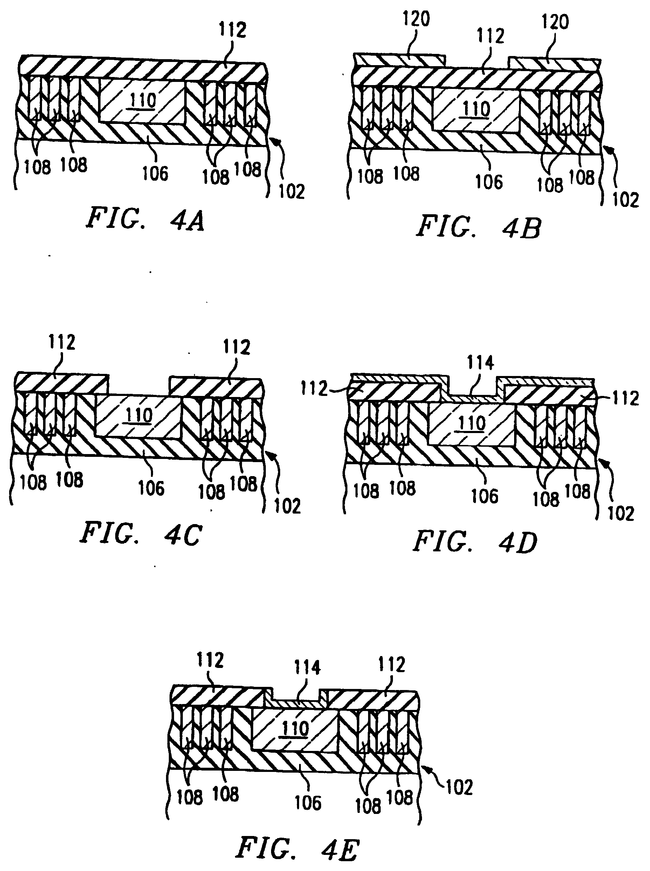

Next, a masking layer 120 is formed over the PO dielectric 112, as shown in FIG. 4B. Masking layer 120 may be formed using a photoresist process to expose portions of the PO dielectric 112 in areas designated as bonding areas (i.e., over pads 110). PO dielectric 112 is then etched using masking layer 120 to expose copper pads 110, as shown in FIG. 4C. Masking layer 120 is then removed and any desired clean-up steps are performed.

Referring to FIG. 4D, a conductive capping layer 114 is deposited over the exposed copper pads 112 and PO dielectric 112. Capping layer 114 may have a thickness on the order of 500-10000 Å. Capping layer 114 comprises a conductive material different from that of the pad 110. The material for capping layer 114 is chosen to provide improved suitability to the bonding process. For example, it must be resistant to corrosion and provide good adhesion for the bondwires 116. The preferred material for capping layer 114 is aluminum or an aluminum alloy with one or more underlying barrier layers. Suitable barrier layers are known in the art. For example, TiN, TiW, Ti or a combination thereof may be used. An aluminum alloy with alloy elements of Cu, Si, Ta is suitable. It should be noted that although the prior art may require an ARC over the aluminum, since there is no resist patterning in the present embodiment, the ARC no longer required.

Next, capping layer 114 is chemically-mechanically polished (CMP'd) as shown in FIG. 4E. The PO dielectric 112 is used as the stopping layer. All of capping layer 114 is removed from over PO dielectric 112. Capping layer 114 thus remains only over copper pads 110. Due to the fact that non-critical dimensions exist for this polish, many suitable pad/slurry combinations are commercially available.

The CMP approach, eliminates a photolithography step from the prior art copper PO flow. Also, it creates a cap 114 that is self-aligned to the copper pad 110. Any misalignment problems at this step are thus, avoided.

A specific example of the invention will now be discussed with reference to FIG. 5. Copper pad 110 is located in semiconductor body 102. PO dielectric 112 consists of a 1500Å layer of nitride 112A, a 4000Å layer of oxide 112B, and a 3000 Å layer of nitride 112C. Cap 114 comprises a first barrier layer 114A of Ti at 200 Å, a second barrier layer 114B of TiN at 1200Å, and an aluminum layer 114C at 6000Å with 0.5% copper. It is preferred that the first layer of PO dielectric 112 be nitride. However, a nitride/oxide/nitride stack is not necessary.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.

## Claims

1. A PO flow for metallization, comprising the steps of:
forming a PO dielectric over a metal interconnect layer;
removing a portion of said PO dielectric over a pad of said metal interconnect layer;
depositing a conductive capping layer over said PO dielectric, said conductive capping layer providing good adhesion to bondwires;
chemically-mechanically polishing said conductive capping layer to remove said conductive capping layer from over said PO dielectric leaving a portion of said conductive capping layer over said pad.

2. A method of fabricating an integrated circuit, comprising the steps of:
forming active components in a semiconductor body;
forming at least one metal interconnect layer over said semiconductor body;
forming a PO dielectric over an upper one of said at least one metal interconnect layer;
removing a portion of said PO dielectric over a pad of said upper metal interconnect layer;
depositing a conductive capping layer over said PO dielectric, said conductive capping layer providing good adhesion to bondwires;
chemically-mechanically polishing said conductive capping layer to remove said conductive capping layer from over said PO dielectric leaving a portion of said conductive capping layer over said pad; and
bonding a bond wire to said portion of said conductive capping layer.

3. The method of claims 1 or 2, wherein said PO dielectric comprises a layer of nitride and an overlying layer of oxide .

4. The method of claims 1 or 2, wherein said conductive capping layer comprises aluminum.

5. The method of claim 4, wherein said capping layer further comprises at least one barrier layer under said aluminum.

6. The method of claim 5, wherein said at least one barrier layer comprises tantalum.

7. The method of claim 5, wherein said at least one barrier layer comprises titanium.

8. The method of claim 5, wherein said at least one barrier layer comprises tungsten-nitride.

9. The method of claim 5, wherein said at least one barrier layer comprises titanium-nitride.

10. The method of claim 5, wherein said at least one barrier layer comprises tantalum-nitride.

11. The method of claim 5, wherein said at least one barrier layer comprises titanium-tungsten.

12. The method of claims 1 or 2, wherein said conductive capping layer comprises an aluminum alloy with alloy elements of Cu, Si, Ta.
